(19) **Europäisches Patentamt / European Patent Office / Office européen des brevets**

(11) **EP 3 671 818 B1**

(12) **FASCICULE DE BREVET EUROPEEN**

(45) Date de publication et mention de la délivrance du brevet:
**15.09.2021 Bulletin 2021/37**

(51) Int Cl.:
***H01L 21/67*** *(2006.01)*

(21) Numéro de dépôt: **19216615.5**

(22) Date de dépôt: **16.12.2019**

(54) **DISPOSITIF DE COLLECTE DE CONTAMINANTS SUR LES BORDS ET LA TRANCHE D'UNE PLAQUE CIRCULAIRE**

SCHADSTOFFSAMMELVORRICHTUNG AN DEN KANTEN UND DEM RAND EINER RUNDEN PLATTE

DEVICE FOR COLLECTING CONTAMINANTS ON THE EDGES AND THE SECTION OF A CIRCULAR PLATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2018 FR 1873425**

(43) Date de publication de la demande:
**24.06.2020 Bulletin 2020/26**

(73) Titulaire: **Commissariat à l'énergie atomique et aux énergies alternatives**
**75015 Paris (FR)**

(72) Inventeurs:
• **AUTILLO, Delphine**
**38054 GRENOBLE CEDEX 09 (FR)**
• **BORDY, Thomas**
**38054 GRENOBLE CEDEX 09 (FR)**
• **BOUTRY, Delphine**
**38054 GRENOBLE CEDEX 09 (FR)**
• **ENYEDI, Virginie**
**38054 GRENOBLE CEDEX 09 (FR)**
• **FLAHAUT, Thierry**
**38054 GRENOBLE CEDEX 09 (FR)**
• **FONTAINE, Hervé**
**38054 GRENOBLE CEDEX 09 (FR)**
• **GARCIA-SANTANA, Roland**
**38054 GRENOBLE CEDEX 09 (FR)**

(74) Mandataire: **Brevalex**
**95, rue d'Amsterdam**
**75378 Paris Cedex 8 (FR)**

(56) Documents cités:
**US-A1- 2016 178 279**

• **CHRIS M. SPARKS ET AL: "<title>Novel technique for contamination analysis around the edge, the bevel, and the edge exclusion area of 200 and 300mm silicon wafers</title>", PROCEEDINGS OF SPIE, vol. 5041, 15 juillet 2003 (2003-07-15), pages 99-104, XP055057683, ISSN: 0277-786X, DOI: 10.1117/12.485233**

EP 3 671 818 B1

**Description**

**DOMAINE TECHNIQUE ET ÉTAT DE LA TECHNIQUE ANTÉRIEURE**

La présente invention se rapporte à un dispositif de collecte par voie liquide de contaminants sur le bord et la tranche de plaques circulaires, par exemple sur des substrats utilisés dans la microélectronique, notamment en vue de l'identification et de la quantification des contaminants, et à une méthode de collecte de contaminants par voie liquide.

Il est très important de pouvoir identifier et quantifier des traces d'éléments métalliques contaminants présents sur un substrat ou wafer dans le domaine de la microélectronique, car ces traces entraînent des baisses des performances électriques. Cette contamination peut survenir à chaque étape de fabrication de circuits électroniques sur un substrat, par exemple en silicium. La contamination peut être due à l'état de propreté d'un équipement et se produire en face arrière et/ou en face avant. La contamination en face arrière ou sur la tranche ou bevel peut également être due aux dispositifs servant à la manipulation des substrats, par exemple les pinces ou les équipements servant à transférer les substrats d'une boîte à l'autre, désignés « sorter », ou encore les boîtes de rangement des substrats.

Différentes techniques existent pour analyser le bord du substrat. Une technique est basée sur la spectrométrie de fluorescence X en réflexion totale ou TXRF (Total reflection X-Ray Fluorescence en terminologie anglo-saxonne), permettant d'avoir 0 mm d'exclusion d'analyse par rapport au bord de la plaque. Une autre technique met en œuvre une collecte par une goutte de liquide et une analyse de cette goutte par spectrométrie de masse à plasma à couplage inductif ou ICP-MS. Cette technique est désignée VPD-DC-ICPMS (Vapor Phase Decomposition - Droplet Collection - Inductively Coupled Plasma Mass Spectrometry en terminologie anglo-saxonne). La collecte des contaminants est composée de deux étapes. La première étape est une étape de décomposition de l'oxyde natif sur la surface de la plaque avec des vapeurs d'acide fluorhydrique rendant la surface hydrophobe. La seconde étape est la collecte des contaminants par circulation d'une goutte de chimie sur la surface de la plaque de silicium.

Avec cette technique, différentes configurations ont été développées permettant de collecter les contaminants soit sur la zone de la tranche (aussi appelée bevel) soit sur la tranche et sur le bord de plaque sur une hauteur d'environ 4-5 mm. Il est difficile de réduire cette hauteur au risque de perdre la goutte dans l'appareil et ne pas pouvoir analyser la contamination. Dans tous les cas, il n'y a pas de moyens de contrôle ou de mesure des zones du substrat effectivement collectées et analysées, la zone mouillée pouvant être dépendante de l'état de surface (rugosité, nature chimique de la surface ou état de contamination). Or, la connaissance de cette surface est importante puisque l'on souhaite corréler la concentration en métaux analysée par ICPMS avec la surface collectée afin de fournir des résultats en at/cm$^2$.

Le document « Novel technique for contamination analysis around the edge, the bevel, and the edge exclusion area of 200 and 300mm silicon wafers". Proceedings of SPIE 5041, Process and Materials Characterization and Diagnostics in IC manufacturing (15 July 2003), Chris M. Sparks et al., 2003, pp. 99-104, doi: 10.1117/12.485233 décrit un dispositif de collecte de contaminants de bord de plaque comprenant un support sur lequel est monté le substrat capable de tourner autour d'un axe horizontal et une gouttière contenant un liquide de collecte et recevant une partie du bord de la plaque. En faisant tourner la plaque sur elle-même, tout le bord de plaque est balayé par le liquide dans la gouttière. Or, la hauteur de la surface de contact du liquide avec le bord de plaque n'est pas connue précisément, en effet elle peut varier du fait des propriétés hydrophiles/hydrophobes de la plaque. En outre, le dispositif utilisé ne permet pas d'effectuer une collecte sur toute la périphérie du substrat.

**EXPOSÉ DE L'INVENTION**

C'est par conséquent un but de la présente invention d'offrir un dispositif de collecte d'éléments situés, soit sur la tranche d'une plaque circulaire, soit sur les bords et sur la tranche d'une plaque circulaire, permettant de connaître la surface de collecte de manière précise.

Le but énoncé ci-dessus est atteint par un dispositif de collecte d'éléments localisés sur la tranche ou sur les bords et la tranche d'une plaque circulaire. Il comporte un support pour la plaque de sorte que la plaque puisse tourner autour de son axe de révolution, une rainure destinée à contenir un liquide de collecte, la rainure étant située par rapport au support de sorte qu'au moins la tranche ou une portion des bords des deux faces et la tranche de la plaque pénètrent dans la rainure et entrent en contact avec le liquide de collecte. Le dispositif comporte également des moyens de visualisation de la zone de contact entre le liquide et la plaque. Les images de la zone de contact fournies par les moyens de visualisation permettent ensuite de mesurer la hauteur de contact entre le liquide de collecte et au moins un bord de plaque et de déterminer précisément la surface sur laquelle la collecte a eu lieu et ainsi calculer la concentration d'éléments collectés.

Grâce à l'invention, en réduisant la hauteur de contact entre le liquide et le substrat, il est possible de réaliser une collecte uniquement sur la tranche du substrat.

Les moyens de visualisation sont par exemple au moins une caméra qui fournit une image en temps réel de la zone de contact. La vitesse de rotation du substrat peut alors être ajustée en temps réel en fonction du mouillage-démouillage du ou des bords du substrat par le liquide.

En d'autres termes, le dispositif de collecte permet d'acquérir des images de zone de collecte et donc de connaître la surface effective de cette zone de collecte.

De manière avantageuse, des moyens d'éclairage de la zone de contact sont prévus. De préférence, les moyens d'éclairage sont disposés de sorte à éclairer la zone de collecte par le dessus.

Le dispositif de collecte peut, en outre, être facilement adapté à différents diamètres de plaques sur lesquelles la collecte a lieu.

De préférence, le fond de la rainure comporte une partie plate permettant de localiser le liquide au fond de la gouttière.

La présente invention a alors pour objet un dispositif de collecte d'éléments sur au moins une tranche d'une plaque circulaire comportant :

- un socle comprenant une rainure de collecte destinée à recevoir un liquide de collecte,
- un porte-plaque apte à faire tourner la plaque sur elle-même et de sorte que la périphérie extérieure de la plaque pénètre dans la rainure de collecte,
- des moyens de visualisation de l'intérieur de la rainure de collecte, permettant d'acquérir au moins une image de la zone de contact entre le liquide de collecte et au moins une des deux faces de la plaque.

Dans un exemple avantageux, les moyens de visualisation comportent au moins une caméra destinée à être connectée à des moyens d'affichage et de traitement des images.

Par exemple, le socle comporte un alésage débouchant dans la rainure, dans lequel est montée une caméra. Dans une variante, les moyens de visualisation permettent d'acquérir au moins une image de la zone de contact entre le liquide de collecte et les deux faces de la plaque, et le socle comporte un autre alésage débouchant dans la rainure à l'opposé du premier alésage, et dans lequel est montée une autre caméra.

Dans un exemple avantageux, le dispositif comporte des moyens d'illumination orientés de sorte à éclairer la rainure de collecte par le dessus.

De préférence, le dispositif comporte des moyens pour modifier la position de pénétration de la plaque dans la rainure de collecte. Par exemple, les moyens pour modifier la position de pénétration de la plaque dans la rainure de collecte comportent un jeu de cales d'épaisseur différentes destinées à être disposées entre le porte-plaque et le socle. Dans un autre exemple, les moyens pour modifier la position de pénétration de la plaque dans la rainure de collecte comportent des vis micrométriques.

Le fond de la rainure de collecte peut avantageusement comporter une modification de la courbure du fond de la rainure destinée à maintenir en position le liquide de collecte.

Le dispositif comporte avantageusement des moyens de mise en rotation du porte substrat de sorte à faire tourner la plaque autour de son axe au moins sur 360° à vitesse constante.

Selon une caractéristique additionnelle, le dispositif comporte des moyens aptes à délivrer un flux gazeux contrôlé dans la rainure de collecte au niveau de la zone de collecte, dirigé en opposition au mouillage du bord de la plaque par la solution de collecte.

La présente invention a également pour objet un système de collecte comportant un dispositif de collecte selon l'invention et une unité de traitement configurée pour commander la position de pénétration de la plaque dans la rainure de collecte, la vitesse de rotation et la rotation et configurée pour traiter les images fournies par les moyens de visualisation afin de déterminer une surface de collecte.

La présente invention a également pour objet un procédé de collecte mettant en œuvre le dispositif de collecte selon l'invention, comportant :

A) mise en place de la plaque sur le porte-plaque,
B) mise en place du liquide de collecte dans la rainure de collecte,
C) mise en place du porte-plaque de sorte que la plaque pénètre dans le liquide de collecte d'une profondeur donnée,
D) mise en rotation de la plaque à une vitesse constante adaptée sur au moins un tour complet, et acquisition d'images de la collecte,
E) retrait de la plaque,
F) récupération du liquide de collecte.

Le procédé peut comporter, préalablement à l'étape A), une étape de mise en place sur le porte-plaque d'une plaque graduée ayant le même diamètre que la plaque sur laquelle on souhaite collecter des éléments et comportant des graduations s'étendant radialement à partir du bord extérieur de la plaque, une étape d'acquisition d'une image de la plaque graduée et de traitement de ladite image de la plaque graduée en vue du traitement des images acquises lors de la collecte. En variante, des graduations sont superposées sur les images de collecte de sorte que les calibrations s'étendant radialement à partir du bord extérieur de la plaque.

Par exemple, pour la collecte des éléments à collecter comprenant des éléments standards et des métaux nobles, le procédé peut comporter une étape de collecte d'éléments standards avec une première solution de collecte suivi d'une étape de collecte de métaux nobles avec une deuxième solution de collecte.

La présente invention a également pour objet un procédé d'établissement d'au moins un abaque de la hauteur de collecte avec le dispositif selon l'invention, en fonction de la profondeur de pénétration de la plaque dans la rainure et du volume du liquide de collecte, comportant

A') Une étape dans laquelle une plaque de calibration présentant les propriétés d'état de surface des plaques sur lesquelles on souhaite collecter des éléments, ayant le même diamètre que celle-ci, et comportant des graduations s'étendant radialement au moins à partir du bord extérieur de la plaque de calibration, est montée sur le porte-plaque, Des étapes de
B') mise en place du liquide de collecte dans la rainure de collecte,
C') mise en place du porte-plaque portant la plaque de calibration de sorte que la plaque pénètre dans le liquide de collecte à une profondeur de pénétration donnée,
D') acquisition d'images,
Puis répétition des étapes C' et D' en modifiant la profondeur de pénétration de la plaque de calibration dans la rainure de collecte,
E') détermination de la hauteur de collecte et le calcul de la surface de collecte pour les différentes profondeurs de pénétration,
F') établissement d'un abaque reliant les profondeurs de pénétration, le volume du liquide de collecte à la surface de collecte.

La vitesse de rotation adaptée peut avantageusement être déterminée lors de la rotation de la plaque de calibration.

La présente invention a également pour objet un procédé de détermination de la concentration surfacique en contaminant métalliques d'une plaque mettant en œuvre le procédé de collecte selon l'invention, et comportant le traitement des images acquises à l'étape D pour déterminer la surface de collecte, l'analyse de la goutte de collecte et le calcul de la concentration surface en contaminant de la plaque.

## BRÈVE DESCRIPTION DES DESSINS

La présente invention sera mieux comprise sur la base de la description qui va suivre et des dessins en annexe sur lesquels :

- les figures 1A à 1C sont des vues différentes en perspective d'un exemple de dispositif de collecte de contaminant sur une plaque,
- la figure 1D est une vue en perspective d'une variante de réalisation du dispositif des figures 1A à 1C mettant en œuvre des vis micrométriques,
- la figure 1E est une vue en coupe longitudinale du dispositif de la figure 1A le long du plan A-A,
- la figure 2 est une représentation en perspective du support de substrat et d'une plaque,
- la figure 3 est une vue en coupe d'un exemple de socle d'un dispositif de collecte,
- la figure 4A est une vue en perspective d'exemples de cales pouvant être mises en œuvre dans le dispositif de collecte,
- la figure 4B est une vue en perspective d'un détail du dispositif de collecte des figures 1A à 1C muni de toutes les cales de la figure 4A,
- la figure 5 est une vue de face d'un substrat de calibration pouvant être mis en œuvre pour la calibration du dispositif de collecte,
- la figure 6 est une vue de face d'un substrat sur laquelle la zone de collecte est représentée,
- la figure 7 est une représentation schématique d'une vue de dessus d'un substrat et des moyens d'illumination adaptées pour l'étape de calibration,

## EXPOSÉ DÉTAILLÉ DE MODES DE RÉALISATION PARTICULIERS

Dans la description qui va suivre, on entend par « substrat » une plaque en forme de disque. Le substrat pourra également être désigné « plaque » dans la description qui va suivre.

On entend par « bord de plaque » ou « bord », une zone située à l'extrémité radiale extérieure du disque et s'étendant sur toute la périphérie du disque, le bord a une forme annulaire centrée sur l'axe de révolution du disque. Le substrat comporte deux faces, et un bord par face.

La tranche est le rebord de la plaque reliant les deux bords. La tranche peut être de forme cylindrique de révolution ou de forme tronconique, désigné « bevel » en anglais.

Dans la présente demande, on entend par « collecte au moins sur la tranche de la plaque » la collecte sur la tranche ou sur la tranche et les bords d'une plaque.

Le dispositif de collecte qui va être décrit ci-dessous est apte à permettre la collecte d'éléments sur la tranche ou sur les bords et la tranche d'un substrat ou plaque en forme de disque. Les éléments seront désignés contaminants.

Le substrat considéré dans la description est un substrat en silicium mis en œuvre dans la fabrication de dispositifs microélectroniques, mais l'invention s'applique à la collecte d'éléments sur tout substrat en forme de disque destiné ou non à l'industrie microélectronique.

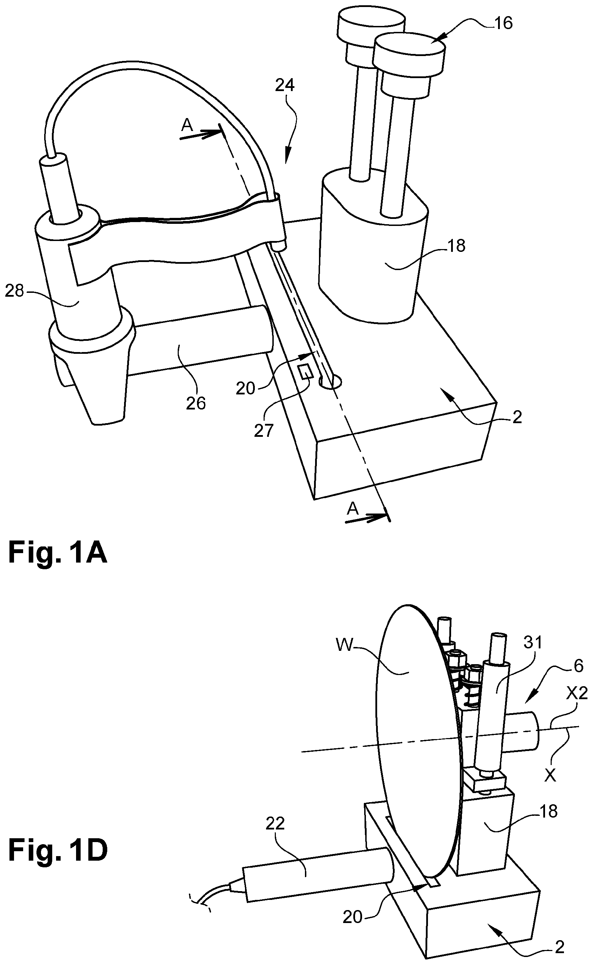

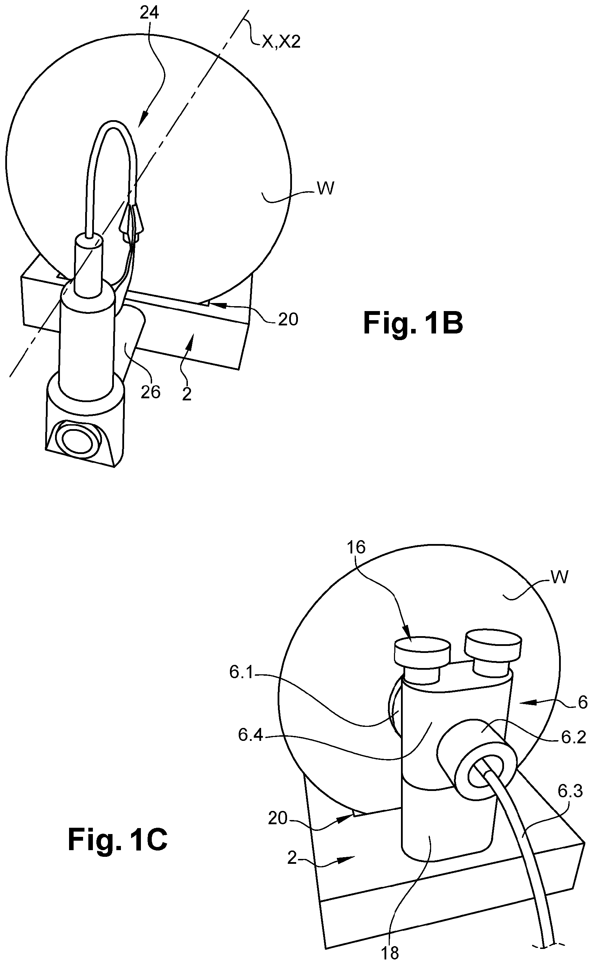

Sur la figure 1A à 1C, on peut voir un exemple de réalisation du dispositif de collecte de contaminants sur un substrat W d'axe de révolution X. Le dispositif de collecte comporte un bâti comportant un socle 2 et un porte-substrat ou porte-plaque 6.

Dans l'exemple représenté, le porte-substrat 6 est configuré pour maintenir le substrat W de sorte que son axe X soit à l'horizontal, et permette une mise en rotation du substrat W autour de son axe X au moins sur 360°. Le porte-substrat 6 est destiné à former un axe de rotation du substrat. De préférence, il comporte des moyens de maintien du substrat sous vide. Le porte-substrat 6 est destiné à être solidarisé à une face du substrat de manière coaxiale à l'axe X.

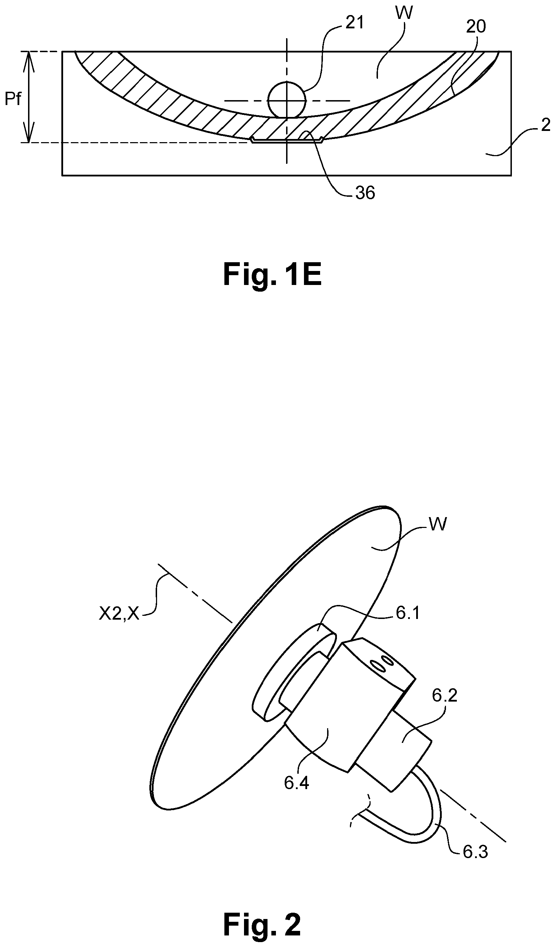

Le porte-substrat comporte une platine 6.1 disposée à l'extrémité longitudinale d'une poignée 6.2. La platine 6.1 est destinée à être en contact avec une face du substrat, et la poignée 6.2 est destinée à la manipulation du porte-substrat. Le porte-substrat 6 comporte des moyens de maintien sous vide du substrat, pour cela des trous (non représentés) sont formés dans la platine 6.1 et sont reliés via la poignée 6.2 à un dispositif de génération de vide au moyen d'un tuyau 6.3. Sur la figure 2, on peut voir une plaque W solidarisée au porte-substrat 6.

Le socle 2 comporte également des moyens pour fixer le porte-substrat 6 au bâti de sorte que l'axe X2 du porte-substrat 6 soit horizontal.

Dans l'exemple représenté sur la figure 1A, les moyens de fixation comportent deux vis 16 orientées verticalement et vissées dans une saillie 18 du socle 2 et destinées à traverser chacune un alésage réalisé dans l'élément de montage 6.4 du porte-substrat 6. Pour la mise en place du support de montage sur le socle, les vis sont retirées, l'élément de montage 6.4 est disposé sur la saillie 18 en alignant les alésages de l'élément de montage 6.4 avec les trous de vis de la saillie, puis les vis sont remises en place en traversant chacune un alésage (figure 1C). L'élément de montage est ainsi solidarisé au socle, l'axe X2 de la poignée étant orientée horizontalement, ainsi que l'axe X. la poignée peut alors tourner librement autour de son axe par rapport au socle 2.

La fixation par vis assure un maintien du porte-substrat 6 et du substrat W et évite tout basculement. En outre, lors de la mise en place du porte-substrat sur le socle, le substrat W est approché verticalement et entre dans la rainure, les risques d'endommagement sont réduits.

Dans l'exemple représenté, le porte-substrat 6 est amovible par rapport au socle 2.

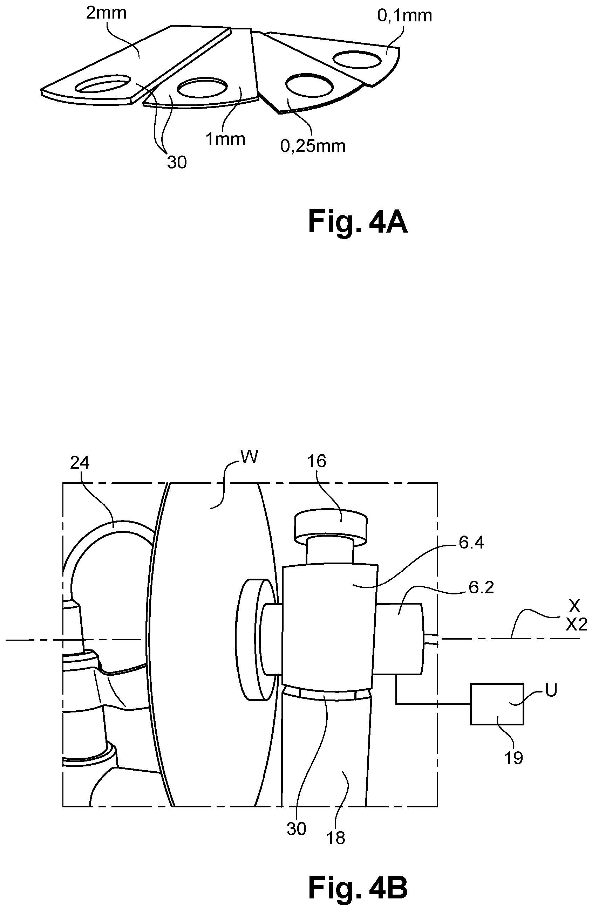

Lors d'une collecte, le porte-substrat et le substrat sont mis en rotation par rapport au socle. Cette rotation peut être obtenue de manière manuelle en agissant à la main sur le porte-substrat 6. Selon une variante avantageuse, des moyens 19 (représentés schématiquement sur la figure 4B) comportant un moteur électrique sont mis en œuvre. Par exemple, le porte-substrat 6 est monté en prise direct sur l'arbre du moteur électrique ou via un réducteur, le moteur étant fixé sur le châssis. La mise en œuvre d'un moteur électrique permet de contrôler plus facilement la vitesse de rotation afin qu'elle soit constante pendant toute la collecte. En outre, le changement de la vitesse de rotation en fonction de l'état de surface du substrat et/ou du diamètre du substrat peut être réalisé aisément. Le moteur est avantageusement commandé par une unité de commande et de traitement U, par exemple un ordinateur.

Le socle 2 comporte une rainure de collecte 20 débouchant dans la face supérieure du socle 2 et disposée par rapport à la saillie 18, de sorte que les bords et la tranche du substrat W pénètrent dans la rainure de collecte 20. De préférence au moins la rainure de collecte 20 est composée d'un matériau qui interagit peu ou pas avec le liquide de collecte, par exemple du PTFE. Dans l'exemple représenté, le socle est en PTFE et la rainure de collecte est usinée dans celui-ci.

De manière encore préférée, tout le dispositif est en un même matériau, par exemple en PTFE.

La distance entre l'axe X2 et le fond de la rainure de collecte 20 est choisie de sorte que la tranche du substrat n'entre pas en contact avec le fond de la rainure.

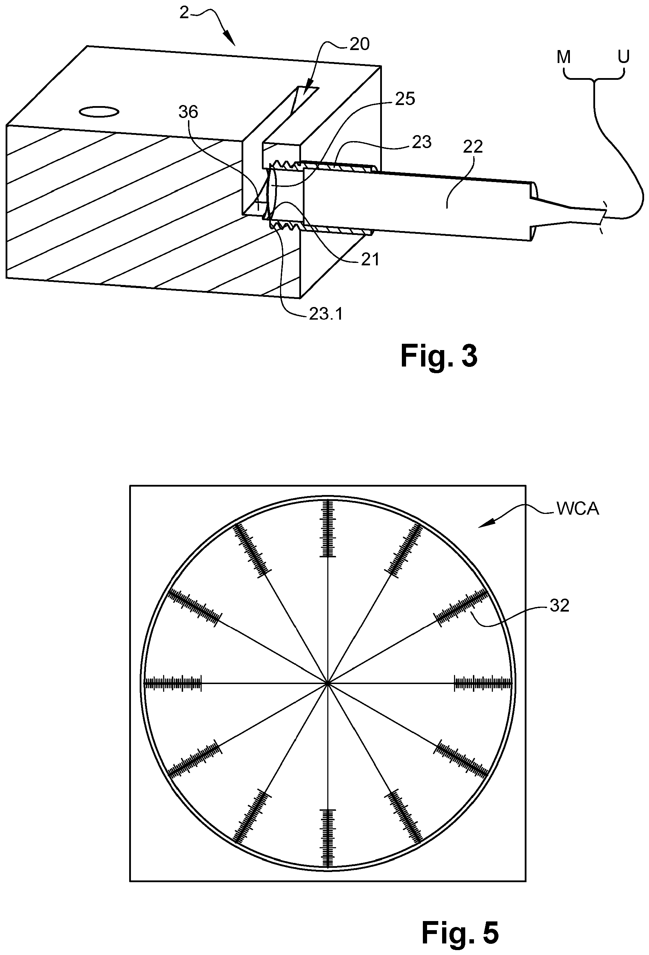

La rainure de collecte 20 a, par exemple, un fond incurvé de diamètre au moins égal au diamètre de la plus grande plaque destinée à être mise en place dans le dispositif de collecte. Par exemple, la rainure a une largeur d'environ 6mm et une profondeur maximale Pf d'environ 29 mm. En variante, la rainure peut présenter une faible profondeur juste suffisante pour la mise en place de la goutte de collecte. Sur les figures 1E et 3, on peut voir une vue en coupe du socle montrant le fond incurvé de la rainure de collecte.

La quantité de liquide de collecte utilisée est très faible, il s'agit d'une goutte, par exemple de volume compris entre 100 µl et 500 µl. De manière très avantageuse, le fond de la rainure 20 comporte des moyens pour maintenir la goutte dans le fond de la rainure, de préférence dans une position centrée, pour éviter qu'elle ne soit emportée par le substrat en rotation. Les moyens de maintien 36 sont par exemple un changement d'incurvation du fond de la rainure (figures 3 et 1E) avec par exemple un fond plat de dimensions suffisantes pour accueillir la goutte.

Le dispositif de collecte comporte des moyens de visualisation 22 de l'intérieur de la rainure de collecte 20 au niveau de la zone de contact entre le liquide de collecte et le substrat. Les moyens de visualisation sont disposés de sorte à permettre de visualiser le liquide de collecte en contact avec au moins une des faces du substrat.

Dans cet exemple, les moyens de visualisation sont disposés de sorte à visualiser la face avant du substrat.

Les moyens de visualisation comportent avantageusement une caméra montée dans le socle de sorte que son objectif débouche en regard de la zone de contact.

Dans l'exemple représenté, le socle 2 comporte un alésage 21 débouchant dans la rainure de collecte 20 et orienté de sorte que l'objectif de la caméra est parallèle à l'axe X. Avantageusement, des moyens pour solidariser la caméra dans l'alésage 21 sont prévus, par exemple il s'agit d'un manchon 23 monté par emmanchement autour de l'objectif de la caméra et vissé dans l'alésage 21. Avantageusement, ce manchon 23 assure un montage étanche. D'autres moyens de solidarisation sont envisageables, par exemple par encliquetage. Les moyens de visualisation sont protégés du liquide. Par exemple, l'extrémité 23.1 du manchon 23 montée dans l'alésage 21 et, par laquelle la prise d'image a lieu, est de préférence obturée par des moyens étanches et transparents pour permettre la prise d'image. Dans l'exemple représenté, un disque 25 en matériau transparent, par exemple en polymère transparent tel que le polymère-perfluoroalkoxy ou PFA, est serré entre l'extrémité 23.1 du manchon 23 et un fond de l'alésage 21 débouchant dans la rainure.

L'utilisation d'une caméra permet de filmer toute l'étape de collecte.

De manière préférée, la caméra est connectée à un moniteur M, permettant de visualiser en temps réel la collecte, et à l'unité de commande et de traitement U.

En variante, les moyens de visualisation comportent un appareil photographique qui prend une série de photographies pendant l'étape de collecte.

Le dispositif de collecte comporte, de préférence, des moyens d'illumination 24 de la zone de collecte. De préférence, ils sont disposés de sorte à éclairer la rainure de collecte 20 par le dessus. Les moyens d'illumination comportent par exemple une ou plusieurs diodes électroluminescentes, ce présentent l'avantage de ne pas chauffer la zone de collecte.

De manière très avantageuse, les moyens d'illumination sont orientables, ce qui permet de modifier la direction de la lumière émise.

Dans l'exemple représenté, le dispositif de collecte comporte un support de caméra 26 intégrant un support 28 des moyens d'illumination.

En variante, le dispositif de collecte comporte des moyens de visualisation permettant de visualiser la face avant et la face arrière du substrat. Pour cela une deuxième caméra ou un deuxième appareil photographique est monté dans un alésage de montage réalisé dans le socle sous la saillie 18, sur laquelle est monté le porte-substrat 6. En variante, on peut envisager de disposer des moyens de visualisation uniquement pour visualiser la face arrière.

De manière avantageuse, le dispositif de collecte comporte des moyens de réglage de la position verticale du support de substrat 6 et donc celle du substrat, afin de modifier la profondeur de pénétration du substrat W dans la rainure de collecte 20 et donc de modifier la hauteur de recouvrement entre le liquide et les faces avant et arrière du substrat W et/ou de s'adapter à différents diamètres de substrat.

Les moyens de réglage comportent par exemple des cales 30 de différentes épaisseurs destinées à être interposées entre la saillie 18 du socle et le support de substrat 6, représentées sur la figure 4A. Plus la cale insérée est épaisse, plus la distance entre l'axe X2 du porte-substrat et le socle 2 est grande. Par exemple, les cales ont une épaisseur comprise entre 0,1 mm et 2 mm. Plusieurs cales de même épaisseur et/ou d'épaisseurs différentes peuvent être empilées. Sur la figure 4B, on peut voir une cale 30 montée entre la saillie 18 et le porte-substrat 6.

Sur la figure 1D, on peut voir une variante de réalisation dans laquelle les moyens de réglage sont de type vis micrométrique 31 à actionnement manuel ou piloté. De tels moyens de réglage permettent un réglage plus fin qu'avec les cales.

En réduisant la hauteur de recouvrement, il est possible de collecter uniquement sur la tranche. En outre, avec les images fournies par les moyens de visualisation, il est possible de vérifier si c'est effectivement le cas et de valider ou non la collecte.

Le dispositif de collecte est de préférence adapté pour effectuer des collectes sur des plaques de différents diamètres par exemple entre 100 mm et 300 mm.

Comme il sera décrit par la suite en fonction des propriétés hydrophiles du substrat, la goutte de collecte a tendance à s'étaler sur la face du substrat. Dans une variante de réalisation, le dispositif de collecte comporte des moyens 27 aptes à délivrer un flux gazeux contrôlé au niveau de la zone de collecte, dirigé en opposition au mouillage du bord de la plaque par la solution de collecte, pour contenir la zone analysée. Le flux gazeux s'oppose aux forces de capillarité. Le gaz utilisé est de préférence un gaz inerte, par exemple l'azote, afin de ne pas modifier les propriétés chimiques de la goutte. Par exemple, le débit de gaz est compris entre 0,1 l/min et 5 l/min.

De préférence, préalablement à l'utilisation du dispositif selon l'invention pour effectuer des collectes, on réalise une série de mesures de hauteur de mouillage et de démouillage pour constituer des abaques de hauteur de mouillage et démouillage en fonction du diamètre du substrat et du volume de goutte. Pour cela on utilise des substrats dits de calibration qui présentent les mêmes dimensions, et de préférence le même état de surface que les substrats à analyser.

Par exemple le substrat de calibration est un substrat en silicium avec oxyde natif.

Le montage du substrat de calibration et des substrats pour lesquels on souhaite faire la collecte peut se faire de la manière suivante.

Tout d'abord le porte-substrat 6 est monté sur le socle dans sa position la plus basse, i.e. sans cale de réglage dans le cas d'un dispositif à cale de réglage ou, en réglant les vis micrométrique de sorte que le porte-substrat dans sa position la plus basse dans le cas d'un dispositif à vis micrométriques.

La plaque est ensuite disposée dans la rainure au moyen d'une pipette à vide. Du fait de la présence du porte-substrat 6, la plaque est maintenue en position sensiblement verticale. La plaque touche le fond de la rainure, mais la rainure aura au préalable été conditionnée, évitant tout risque de contamination supplémentaire du fait de ce contact.

Le porte-substrat 6 est ensuite solidarisé à la plaque par aspiration. Dans cette position, le porte-substrat se solidarise au centre de la plaque de sorte que les axe X et X2 soient coaxiaux.

Le porte-substrat 6 et la plaque sont relevés pour permettre la mise en place de la goutte.

En variante, afin de limiter le contact entre la plaque et la rainure, deux cales sont mises en place aux extrémités de la rainure 20, sur lesquelles la plaque vient reposer, réduisant la surface de contact entre la plaque et un élément extérieur. Ces cales auront au préalable été conditionnées.

On considère, dans la présente demande, que l'état de surface d'une face d'une plaque est défini par au moins le niveau de rugosité de la face et la composition de la face. Par exemple, lorsqu'on souhaite analyser des substrats de silicium avec oxyde natif, on utilise comme substrat de calibration un substrat de silicium avec oxyde natif.

On réalise ensuite, sur au moins une des deux faces, des graduations s'étendant radialement à partir de l'extérieur du substrat permettant ainsi, lorsque le substrat de calibration est dans la rainure de collecte, de pouvoir mesurer directement via la caméra la hauteur de contact entre la goutte et la face avant. Sur la figure 5, on peut voir un exemple de plaque de calibration WCA sur laquelle les graduations 32 sont disposées à 30° les unes par rapport aux autres et s'étendent sur une hauteur de 3 cm à partir de l'extérieur de la plaque, avec un pas de 0,1 mm.

En variante, dans le cas d'un dispositif comportant des moyens de visualisation des faces avant et arrière, on peut utiliser un disque comportant des graduations sur ses faces avant et arrière pour mesurer la hauteur de mouillage sur les deux faces simultanément. En variante, le substrat est retourné de sorte que sa face arrière se retrouve face à la caméra.

Par exemple, pour fabriquer un substrat de calibration des étapes de photolithographie/gravure sont mises en œuvre. Par exemple, on réalise lors d'une première étape un masque de lithographie comportant le motif des graduations et leur emplacement. Puis, lors d'une deuxième étape, on fait une gravure du substrat silicium ayant les dimensions et l'état de surface des plaques à analyser, par lithographie et gravure.

Ce substrat gradué est mis en place dans le dispositif, une goutte de liquide de collecte est disposée dans la rainure et on visualise la hauteur de mouillage et la hauteur de démouillage qui sont mesurées grâce aux graduations. Le substrat gradué n'est pas mis en rotation.

On recommence ces mesures avec différents volumes de goutte et différentes profondeurs de pénétration du substrat dans la rainure. On rassemble ainsi les hauteurs de mouillage et de démouillage pour différentes profondeurs de pénétration et différents volumes de gouttes, ce qui permet de constituer des abaques qui seront utilisés pour choisir les conditions opératoires.

L'étape de réalisation d'abaques comporte le montage de la plaque de calibration sur le porte-substrat 6 et le montage du porte-substrat sur le socle 2 et la mise en place du liquide de collecte dans la rainure de collecte 20.

Les moyens de visualisation sont activés.

Le substrat est alors mis en rotation.

Dans le cas du silicium avec oxyde natif, les faces du substrat présentent des propriétés hydrophiles. Le liquide de collecte est choisi pour décomposer l'oxyde natif. Il en résulte que les faces du substrat en contact avec le liquide de collecte deviennent hydrophobes. Lors d'une première phase dite phase de mouillage, la goutte « s'étale » sur la face du substrat du fait de son hydrophilie. Puis, lors d'une deuxième phase dite phase de démouillage, lorsque l'oxyde natif a été décomposé, la goutte se rétracte. Grâce à la visualisation des images du contact entre le liquide de collecte et au moins l'une des faces du substrat de calibration, on mesure la hauteur de la goutte en phase de mouillage et la hauteur de la goutte en phase de démouillage. Le passage de la phase de mouillage à la phase de démouillage est de l'ordre de 10 s pour un oxyde natif. La vitesse de rotation du substrat est choisie en fonction de la durée du passage de la phase de mouillage à la phase de démouillage.

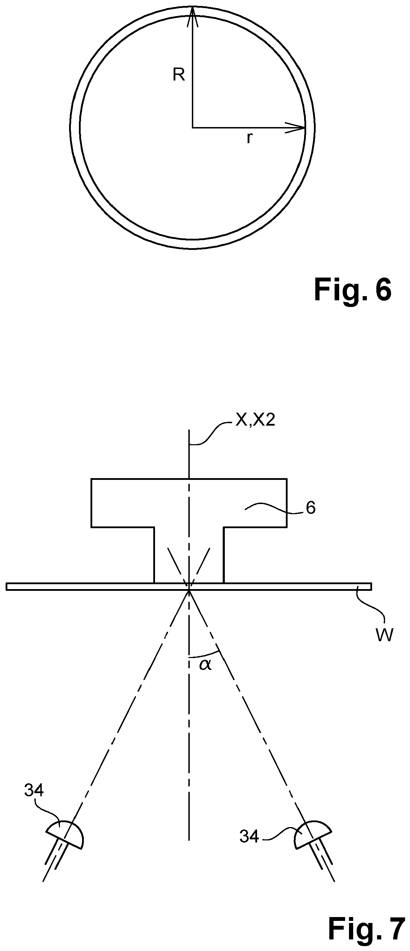

De manière très avantageuse, lorsque les graduations ne sont pas contrastées par rapport à la plaque, il est préférable d'éclairer la plaque de calibration graduée avec au moins une ou plusieurs sources lumineuses 34 (figure 7). De manière préférée, la source lumineuse 34 est orientée de sorte à être en regard de la face du substrat portant les graduations et de sorte que son axe soit incliné par rapport à la face du substrat, avantageusement d'un angle α compris entre 5° et 15°. Cela permet d'obtenir un contraste optimal entre le silicium et les graduations. La ou les sources lumineuses comportent par exemple une ou plusieurs diodes électroluminescences disposées en couronne.

Dans le cas où les gravures sont contrastées par rapport au matériau de la plaque, un éclairage peut être omis.

En variante, on réalise une image de la graduation qui est superposée sur une image de la goutte sur la plaque. Il n'est alors plus requis d'utiliser un substrat gradué.

Le tableau T1 ci-dessous regroupe les mesures de hauteur de mouillage et de démouillage, ainsi que la surface collectée, en fonction de la hauteur totale de cales ajoutées, pour un substrat de 200 mm en silicium avec oxyde natif et une goutte de 200μl.

Le liquide de collecte est un mélange d'acide fluorhydrique et d'eau oxygénée. Celui-ci permet de collecter les métaux non nobles.

**Tableau T1**

| LPD bevel métaux standard HF /H$_2$O$_2$ | | | | | | |
|---|---|---|---|---|---|---|
| Type plaque | Taille plaque | Volume goutte | Hauteur cale | Mouillage | Démouillage | Surface collectée |
| Si oxyde natif graduée | 200mm | 200μL | 0 | 5,1mm | 3,1mm | 37,25cm$^2$ |
| | | | 1mm | 5mm | 2,5mm | 36,64cm$^2$ |
| | | | 2mm | 3,7mm | 1,4mm | 28,65cm$^2$ |
| | | | 3mm | 2,3mm | bevel | 19,98cm$^2$ |
| | | | 3,25mm | 2,3mm | bevel | 19,98cm$^2$ |
| | | | 3,35mm | 2,2mm | bevel | 19,36cm$^2$ |
| | | | 3,4mm | pas de contact | | |

Ces mesures sont faites avec une incertitude de 0,1 mm.

A partir de ce tableau, l'opérateur peut choisir la hauteur de cale à ajouter en fonction de la surface de collecte souhaitée. Lorsque le dispositif est équipé de vis micrométriques, un abaque peut être réalisé comportant le réglage des vis correspondant à la surface collectée, l'opérateur règle alors les vis micrométriques suivant le réglage indiqué.

Lors de la calibration, la vitesse de rotation la plus adaptée peut être déterminée. En effet, celle-ci est choisie de sorte que la goutte soit encore en contact avec la plaque au début de la phase de démouillage, i.e. lorsque la désoxydation de la zone de contact est terminée. En outre, la vitesse de rotation est choisie également de sorte à ne pas perdre du liquide de collecte.

La surface collectée comprend la surface balayée par la goutte en face avant, la surface balayée par la goutte en face arrière et la surface de la tranche.

Si la hauteur collectée est différente entre la face arrière et la face avant, alors

$$S = \pi \, [R^2 - r^2] + \pi \, [R^2 - r'^2] + 2\pi R h \; \text{(II)}$$

Avec R = Rayon extérieur, r et r' = rayons intérieurs pour la face avant et la face arrière respectivement et h = hauteur de la tranche de la plaque (figure 6).

Si on ne collecte que sur la tranche alors $S = 2\pi R h$

Le rayon intérieur est calculé en faisant la différence entre le rayon extérieur et la hauteur de la zone collectée. La hauteur collectée correspond à la hauteur de mouillage que l'on définit par le système de caméra et traitement d'image.

Dans le cas où la surface collectée en face arrière est identique à celle en face avant, $S = 2\,\pi \, [R^2 - r^2] + 2\,\pi R\, h$ (I).

La méthode de collecte, utilisant le dispositif de collecte décrit ci-dessus, va maintenant être décrite.

Elle peut comporter les étapes suivantes :

a) mise en place et solidarisation de la plaque de calibration graduée sur le support de substrat comme décrit ci-dessus,

b) mise en place de la plaque de calibration sur le socle, avec la hauteur de cale souhaitée sélectionnée,

c) allumage des moyens de visualisation et éventuellement des moyens d'illumination et mise au point des moyens de visualisation afin d'avoir une image du substrat de calibration

d) prise d'une image du substrat de calibration et retrait du substrat de calibration,

e) avantageusement, conditionnement de la rainure de collecte avec du liquide de collecte, et avantageusement conditionnement d'un embout de pipette servant au prélèvement de la solution destinée à former la goutte de collecte,

f) mise en place du substrat à analyser sur le porte-substrat comme décrit ci-dessus,

g) sélection de la hauteur de cale souhaitée à partir du tableau T1 ou grâce aux vis micrométriques à partir d'un autre tableau

h) mise en place du liquide de collecte dans la rainure de collecte, de préférence entre les encoches,

i) montage du porte-substrat sur le socle,

j) mise en rotation du porte-substrat à une vitesse constante sélectionnée en fonction du mouillage/démouillage du substrat jusqu'à ce que le substrat ait fait un tour complet. La vitesse de rotation est par exemple d'1 tour en environ 2 min pour une plaque de silicium avec oxyde natif de 200 mm et un tour en environ 4 min pour une plaque de silicium avec oxyde natif de 300 mm.

Le substrat peut comporter une encoche ou un méplat. Avantageusement le substrat est orienté pour que le début de la collecte commence à l'encoche ou au méplat. Ainsi, on dispose d'un repère pour savoir quand un tour complet a été effectué, et simultanément on réalise l'acquisition d'images de la collecte, soit en continu, soit en prenant des photographies à intervalle régulier ou non.

k) retrait du substrat et du support de substrat,

l) récupération du liquide de collecte.

L'étape c) peut s'effectuer comme suit, on dispose un substrat de calibration sur le dispositif en ayant choisi préalablement les conditions opératoires à partir des abaques. On calibre les moyens de visualisation à l'aide du substrat de calibration de sorte que le contraste et la visualisation des graduations soient satisfaisants. Pour cette calibration des moyens de visualisation, la présence d'une goutte de liquide dans la rainure n'est pas requise.

En variante, on peut mettre en place une pastille transparente graduée reprenant les graduations du disque de calibration devant l'objectif, par exemple au niveau du disque transparent 25, ou on peut superposer une image comprenant les graduations à une image de la goutte qui mouille la surface de la plaque, dans ce cas les étapes a) à d) ne sont pas effectuées.

En variante encore, lorsque le dispositif comporte des vis micrométriques, on utilise une pastille transparente graduée comportant les graduations du disque de calibration est disposée devant l'objectif de la caméra, ainsi les graduations apparaissent directement sur les images et/ou le film. L'opérateur peut alors manipuler les vis micrométriques pour placer la plaque à la position correspondant à la hauteur de collecte souhaitée en visualisant en direct la position de la plaque par rapport aux graduations portées par la mire. En variante, les graduations apparaissent sur l'écran grâce au logiciel de visualisation. De préférence, le substrat est placé à une hauteur élevée et est ensuite abaissée jusqu'à atteindre la hauteur de liquide désirée sur le substrat

De préférence, un ou plusieurs blancs de la rainure de collecte est ou sont réalisés avant de mettre la goutte de liquide de collecte à l'étape h). Pour cela, une goutte de liquide est mise dans la rainure de collecte, puis est récupérée en vue d'une analyse. Les résultats seront retranchés à ceux de l'analyse de la goutte ayant servi à la collecte.

La goutte ayant servi à la collecte est ensuite analysée par exemple par ICP-MS. L'analyse est à la fois quantitative et qualitative, et les résultats de l'analyse permettent d'identifier les contaminants collectés et la quantité de ces contaminants en $\mu$g/L ou ppb massique (part per billion ou partie par milliard).

On souhaite convertir ces résultats en at/cm$^2$, unité généralement utilisée en microélectronique pour la contamination métallique.

La surface de collecte est alors calculée en traitant les images acquises lors de la collecte.

Par exemple, la photographie du substrat de calibration est traitée en réalisant un seuillage au moyen d'un logiciel adapté, pour ne récupérer que les graduations formant une mire qui est appliquée sur les images de la collecte. Les réglages des moyens de visualisation, et éventuellement ceux des moyens de réglage lors de l'acquisition de la mire, sont ceux utilisés lors de la collecte.

En variante, un masque est réalisé à partir de l'image prise des substrats de calibration à l'étape c). Ce masque est ensuite mis en surimpression sur les images acquises lors de la collecte.

Le positionnement de la mire tient compte de la hauteur de cale appliquée pour la collecte.

Il est alors possible de mesurer la hauteur de mouillage et la hauteur de démouillage sur chaque image et d'en déduire la hauteur de collecte.

La surface totale de collecte qui comporte les surfaces des deux bords de substrat et la tranche est calculée à partir de la formule (I).

La concentration est ensuite calculée en utilisant la formule :

$$C = \frac{V \times c \times 0,000001 \times N_A}{M \times S} \quad (II)$$

Avec C = concentration en at/cm², V = volume de solution à analyser (L), c = concentration ($\mu$g/L), $N_A$ = nombre d'Avogadro ($6,02.10^{23}$ at.mol$^{-1}$), M = masse molaire de l'élément analysé (g/mol) et S = surface scannée (cm²).

A titre d'exemple, on peut utiliser une solution de collecte pour les métaux nobles et une solution de collecte pour les éléments standards (tous les éléments du tableau périodique qui ne font pas partie des métaux nobles).

Il est possible de faire les deux collectes successivement, de préférence la collecte des éléments standards a lieu avant la collecte des métaux nobles (le Ruthénium (Ru), le Rhodium (Rh), le Palladium (Pd), l'Argent (Ag), l'Iridium (Ir), le platine (Pt), l'or (Au), l'Osmium (Os).

Par exemple, pour la collecte des métaux nobles, on utilise une solution préparée à partir d'acide chlorhydrique à 37 %, d'acide nitrique à 69,5 % et d'acide fluorhydrique à 49 %. La collecte des éléments standards peut être faite avec une solution préparée à partir d'acide fluorhydrique à 38 % et d'eau oxygénée à 35 %.

Nous allons maintenant donner des résultats montrant l'efficacité de la méthode pour détecter qualitativement les contaminants sur la tranche de plaques. Pour cela, on analyse deux plaques de silicium avec oxyde natif, l'une trempée dans un bain $H_3PO_4$ contenant des espèces métalliques et l'autre dans un bain $H_2C_2O_4$ contenant également des espèces métalliques.

Dans ces exemples, la hauteur de collecte a été choisie faible pour se rapprocher de la collecte de contaminants sur la tranche (bevel) seule quasiment. Une hauteur de cale de 3,35 mm donnant une hauteur de mouillage de 2,2 mm a été choisie à partir du tableau T1.

La collecte sur chacun des substrats est réalisée suivant les étapes a) à k) décrites ci-dessus et la goutte de collecte est analysée par ICP-MS.

Le tableau T2 ci-dessous regroupe les contaminants et leur quantité en ppb pour chaque plaque (ligne $H_3PO_4$ (ppb) et $H_2C_2O_4$ (ppb)).

| Éléments | Na | Mg | Al | Ca | Ti | V | Cr |
|---|---|---|---|---|---|---|---|
| $H_3PO_4$ (ppb) | 0,85 | ND | ND | 0,55 | 0,03 | 0,01 | 0,03 |
| $H_2C_2O_4$ (ppb) | ND | 0,14 | 2,55 | 0,14 | 0,08 | ND | 0,09 |
| LLD ICPMS (ppb) | 0,1129 | 0,0044 | 0,0305 | 0,0654 | 0,0138 | 0,0034 | 0,0140 |
| MM | 22,9000 | 24,3 | 26,9 | 40 | 47,8 | 50,9 | 52 |
| At/cm² $H_3PO_4$ bevel | 1,16E+12 | ND | ND | 4.30E+11 | 1.97E+10 | 6.12E+09 | 2.04E+10 |
| At/cm² $H_2C_2O_4$ bevel | ND | 1.82E+11 | 2.95E+12 | 1.06E+11 | 4.92E+10 | ND | 5.46E+10 |

| Éléments | Mn | Fe | Ni | Co | Cu | Zn | Mo |
|---|---|---|---|---|---|---|---|
| $H_3PO_4$ (ppb) | ND | ND | 0,03 | ND | 0,03 | 0,08 | 0,07 |
| $H_2C_2O_4$ (ppb) | 0,06 | 2,45 | 0,32 | 0,00 | 0,31 | 0,13 | 0,02 |
| LLD ICPMS2 (ppb) | 0,0005 | 0,0180 | 0,0004 | 0,0020 | 0,0040 | 0,0257 | 0,0135 |
| MM | 24,9 | 55,8 | 58,6 | 58,9 | 63,5 | 65,3 | 95,9 |
| At/cm² $H_3PO_4$ bevel | ND | ND | 1,39E+10 | ND | 1,54E+10 | 3,66E+10 | 2,15E+10 |
| At/cm² $H_2C_2O_4$ bevel | 7,74E+10 | 1,37E+12 | 1,69E+11 | 0,00E+00 | 1,50E+11 | 6,01E+10 | 5,13E+09 |

ND : not detected (non détecté)

LLD : Low Limit of Detection (limite de detection).

**Tableau T2:**

Avec MM la masse molaire de l'élément analysé.

Dans la variante avantageuse mettant en œuvre un système motorisé pour mettre en rotation le porte-substrat, l'ensemble de la collecte peut être très avantageusement piloté par l'unité de commande et de traitement U mettant en œuvre un logiciel, qui contrôle le démarrage et l'arrêt de la collecte par rapport à l'encoche ou du méplat et qui enclenche l'enregistrement des images de la collecte et récupère les images. La détection de l'encoche ou du méplat est faite par exemple en analysant les images fournies par les moyens de visualisation.

Ce logiciel peut également assurer le traitement des images pour calculer automatiquement la hauteur de collecte et donc la surface collectée, et ainsi permettre de calculer la concentration en métaux, dès que l'analyse quantitative et qualitative de la goutte de collecte est effectuée.

En outre il peut également être prévu que l'unité de commande et de traitement de contrôle la position du porte-substrat, par exemple en mettant en œuvre une vis micrométrique motorisée, après avoir choisi la hauteur de collecte en tenant compte par exemple de la nature de la plaque utilisée, de la solution de collecte et/ou du type de collecte souhaitée, i.e. une collecte sur approximativement la tranche seule ou sur la tranche et sur les bords.

De manière avantageuse, l'unité de commande et de traitement peut être configurée pour arrêter la descente du substrat quand il y a détection du contact entre la plaque et la goutte, par exemple par analyse en temps réel des images fournies par les moyens de visualisation.

Dans l'exemple décrit, les plaques analysées sont initialement hydrophiles et la solution de collecte rend hydrophobe la zone de collecte. Il sera compris que la collecte peut être effectuée directement sur une plaque présentant des propriétés hydrophobes, la solution de collecte étant alors adaptée.

Dans l'exemple décrit, lors de la collecte la plaque est mise en rotation autour d'un axe horizontal. En variante, elle est mise en rotation autour d'un axe incliné, permettant par exemple de réduire la surface de collecte sur la face avant ou la face arrière.

## Revendications

1. Dispositif de collecte d'éléments sur au moins une tranche d'une plaque circulaire (W) comportant :

   - un socle (2) comprenant une rainure de collecte (20) destinée à recevoir un liquide de collecte,
   - un porte-plaque (6) apte à faire tourner la plaque (W) sur elle-même et de sorte que la périphérie extérieure de la plaque (W) pénètre dans la rainure de collecte (20), ledit dispositif étant **caractérisé en ce qu'**il comprend de plus:
   - des moyens de visualisation (22) de l'intérieur de la rainure de collecte (20), permettant d'acquérir au moins une image de la zone de contact entre le liquide de collecte et au moins une des deux faces de la plaque.

2. Dispositif de collecte selon la revendication 1, dans lequel les moyens de visualisation (20) comportent au moins une caméra destinée à être connectée à des moyens d'affichage et de traitement des images, le socle (2) comportant avantageusement un alésage (21) débouchant dans la rainure (20), dans lequel est montée une caméra.

3. Dispositif de collecte selon la revendication 2, dans lequel les moyens de visualisation (22) permettent d'acquérir au moins une image de la zone de contact entre le liquide de collecte et les deux faces de la plaque, et dans lequel le socle (2) comporte un autre alésage débouchant dans la rainure à l'opposé du premier alésage et dans lequel est montée une autre caméra.

4. Dispositif de collecte selon l'une des revendications 1 à 3, comportant des moyens d'illumination (24) orientés de sorte à éclairer la rainure de collecte (20) par le dessus.

5. Dispositif de collecte selon l'une des revendications 1 à 4, comportant des moyens pour modifier la position de pénétration de la plaque (W) dans la rainure de collecte (20), lesdits moyens (20) comportant avantageusement un jeu de cales (30) d'épaisseur différentes destinées à être disposées entre le porte-plaque (6) et le socle (2) ou lesdits moyens (20) comportant avantageusement des vis micrométriques.

6. Dispositif de collecte selon l'une des revendications précédentes, dans lequel le fond de la rainure de collecte (20) comporte une modification de la courbure du fond de la rainure destinée à maintenir en position le liquide de collecte et/ou le dispositif comportant des moyens de mise en rotation du porte plaque de sorte à faire tourner la plaque autour de son axe au moins sur 360° à vitesse constante.

7. Dispositif de collecte selon l'une des revendications précédentes, comportant des moyens (27) aptes à délivrer un flux gazeux contrôlé dans la rainure de collecte (20) au niveau de la zone de collecte, dirigé en opposition au mouillage du bord de la plaque (W) par le liquide de collecte.

**8.** Système de collecte comportant un dispositif de collecte selon l'une des revendications 1 à 7 et une unité de traitement configurée pour commander la position de pénétration de la plaque dans la rainure de collecte, la vitesse de rotation et la rotation, et configurée pour traiter les images fournies par les moyens de visualisation afin de déterminer une surface de collecte.

**9.** Procédé de collecte mettant en œuvre le dispositif de collecte selon l'une des revendications 1 à 7 ou un système de collecte selon la revendication 8, comportant :

A) mise en place de la plaque sur le porte-plaque,
B) mise en place du liquide de collecte dans la rainure de collecte,
C) mise en place du porte-plaque de sorte que la plaque pénètre dans le liquide de collecte d'une profondeur donnée,
D) mise en rotation de la plaque à une vitesse constante adaptée sur au moins un tour complet, et acquisition d'images de la collecte,
E) retrait de la plaque,
F) récupération du liquide de collecte.

**10.** Procédé de collecte selon la revendication 9, comportant, préalablement à l'étape A), une étape de mise en place sur le porte-plaque d'une plaque graduée ayant le même diamètre que la plaque sur laquelle on souhaite collecter des éléments et comportant des graduations s'étendant radialement à partir du bord extérieur de la plaque, une étape d'acquisition d'une image de la plaque graduée et de traitement de ladite image de la plaque graduée en vue du traitement des images acquises lors de la collecte.

**11.** Procédé de collecte selon la revendication 10, dans lequel une vitesse de rotation adaptée est déterminée lors de la rotation de la plaque graduée, ladite plaque graduée agissant comme une plaque de calibration.

**12.** Procédé de collecte selon la revendication 10, dans laquelle des graduations sont superposées sur les images de collecte de sorte que les graduations s'étendent radialement à partir du bord extérieur de la plaque.

**13.** Procédé de collecte selon l'une des revendications 9 à 12, les éléments à collecter comprenant des éléments standards et des métaux nobles, ledit procédé comportant une étape de collecte d'éléments standards avec un premier liquide de collecte suivi d'une étape de collecte de métaux nobles avec un deuxième liquide de collecte.

**14.** Procédé d'établissement d'au moins un abaque de la hauteur de collecte avec le dispositif selon l'une des revendications 1 à 7, en fonction de la profondeur de pénétration de la plaque dans la rainure et du volume du liquide de collecte, comportant

A') Une étape dans laquelle une plaque de calibration présentant les propriétés d'état de surface des plaques sur lesquelles on souhaite collecter des éléments, ayant le même diamètre que celle-ci, et comportant des graduations s'étendant radialement au moins à partir du bord extérieur de la plaque de calibration, est montée sur le porte-plaque,
Des étapes de
B') : mise en place du liquide de collecte dans la rainure de collecte,
C') : mise en place du porte-plaque portant la plaque de calibration de sorte que la plaque pénètre dans le liquide de collecte à une profondeur de pénétration donnée,
D') : acquisition d'images,
Puis répétition des étapes C' et D' en modifiant la profondeur de pénétration de la plaque de calibration dans la rainure de collecte,
E') détermination de la hauteur de collecte et le calcul de la surface de collecte pour les différentes profondeurs de pénétration,
F') établissement d'un abaque reliant les profondeurs de pénétration, le volume du liquide de collecte à la surface de collecte.

**15.** Procédé de détermination de la concentration surfacique en contaminant métalliques d'une plaque mettant en œuvre le procédé de collecte selon l'une des revendications 9 à 13, et comportant le traitement des images acquises à l'étape D pour déterminer la surface de collecte, l'analyse du liquide de collecte et le calcul de la concentration surface en contaminant de la plaque.

**Patentansprüche**

1.  Vorrichtung zum Sammeln von Elementen auf wenigstens einem Rand einer kreisförmigen Platte (W), umfassend:

    - einen Sockel (2), umfassend eine Sammelnut (20), welche dazu ausgebildet ist, eine Sammelflüssigkeit aufzunehmen,
    - einen Plattenhalter (6), der dazu geeignet ist, die Platte (W) um sich selbst zu drehen und derart, dass der Außenumfang der Platte (W) in die Sammelnut (20) eindringt,
    wobei die Vorrichtung **dadurch gekennzeichnet ist, dass** sie ferner umfasst:
    - Visualisierungsmittel (22) des Inneren der Sammelnut (20), die es ermöglichen, wenigstens ein Bild der Kontaktzone zwischen der Sammelflüssigkeit und wenigstens einer der beiden Flächen der Platte aufzunehmen.

2.  Sammelvorrichtung nach Anspruch 1, wobei die Visualisierungsmittel (20) wenigstens eine Kamera umfassen, die dazu bestimmt ist, mit Mitteln zur Anzeige und Verarbeitung von Bildern verbunden zu werden, wobei der Sockel (2) vorteilhafterweise eine in die Nut (20) mündende Bohrung (21) umfasst, in der eine Kamera angebracht ist.

3.  Sammelvorrichtung nach Anspruch 2, wobei es die Visualisierungsmittel (22) ermöglichen, wenigstens ein Bild der Kontaktzone zwischen der Sammelflüssigkeit und den beiden Flächen der Platte aufzunehmen, und wobei der Sockel (2) eine weitere Bohrung aufweist, die in die Nut gegenüber der ersten Bohrung mündet und in der eine weitere Kamera angebracht ist.

4.  Sammelvorrichtung nach einem der Ansprüche 1 bis 3, umfassend Beleuchtungsmittel (24), die derart ausgerichtet sind, dass sie die Sammelnut (20) von oben beleuchten.

5.  Sammelvorrichtung nach einem der Ansprüche 1 bis 4, umfassend Mittel zum Verändern der Eindringposition der Platte (W) in die Sammelnut (20), wobei die Mittel (20) vorteilhafterweise einen Satz von Passscheiben (30) unterschiedlicher Dicke umfassen, welche dazu bestimmt sind, zwischen dem Plattenhalter (6) und dem Sockel (2) angeordnet zu werden, oder wobei die Mittel (20) vorteilhafterweise mikrometrische Schrauben umfassen.

6.  Sammelvorrichtung nach einem der vorhergehenden Ansprüche, wobei der Boden der Sammelnut (20) eine Modifikation der Krümmung des Bodens der Nut aufweist, die dazu bestimmt ist, die Sammelflüssigkeit in Position zu halten, und/oder die Vorrichtung Mittel zum Drehen des Plattenhalters umfasst, um die Platte mit konstanter Geschwindigkeit um wenigstens 360° um ihre Achse zu drehen.

7.  Sammelvorrichtung nach einem der vorhergehenden Ansprüche, umfassend Mittel (27), die dazu in der Lage sind, in der Sammelnut (20) auf Höhe der Sammelzone einen kontrollierten Gasstrom abzugeben, der gegen die Benetzung des Randes der Platte (W) durch die Sammelflüssigkeit gerichtet ist.

8.  Sammelsystem, das eine Sammelvorrichtung nach einem der Ansprüche 1 bis 7 und eine Verarbeitungseinheit umfasst, die dazu ausgebildet ist, die Eindringposition der Platte in der Sammelnut, die Rotationsgeschwindigkeit und die Rotation zu steuern, und die dazu ausgebildet ist, die von der Visualisierungsvorrichtung gelieferten Bilder zu verarbeiten, um eine Sammelfläche zu bestimmen.

9.  Sammelverfahren unter Anwendung der Sammelvorrichtung nach einem der Ansprüche 1 bis 7 oder eines Sammelsystems nach Anspruch 8, umfassend:

    A) Aufsetzen der Platte auf den Plattenhalter,
    B) Einbringen der Sammelflüssigkeit in die Sammelnut,
    C) Platzieren des Plattenhalters derart, dass die Platte um eine vorgegebene Tiefe in die Sammelflüssigkeit eindringt,
    D) Drehen der Platte mit einer geeigneten konstanten Geschwindigkeit, die für wenigstens eine vollständige Umdrehung und Erfassen von Bildern der Sammlung geeignet ist,
    E) Entfernen der Platte,
    F) Rückgewinnung der Sammelflüssigkeit.

10. Sammelverfahren nach Anspruch 9, umfassend vor Schritt A) einen Schritt des Anbringens einer graduierten Platte auf dem Plattenhalter, welche den gleichen Durchmesser hat wie die Platte, auf der Elemente gesammelt werden sollen, und welche Graduierungen aufweist, die sich radial vom äußeren Rand der Platte erstrecken, einen Schritt des Erfassens eines Bildes der graduierten Platte und der Verarbeitung des Bildes der graduierten Platte für die Verarbeitung der während des Sammelns erfassten Bilder.

11. Sammelverfahren nach Anspruch 10, wobei beim Drehen der als Kalibrierungsplatte fungierenden graduierten Platte eine geeignete Drehgeschwindigkeit ermittelt wird, wobei die graduierte Platte als Kalibrierungsplatte dient.

12. Sammelverfahren nach Anspruch 10, wobei die Bilder der Sammlung mit einer Skala überlagert sind, so dass sich die Skala radial vom äußeren Rand der Platte erstreckt.

13. Sammelverfahren nach einem der Ansprüche 9 bis 12, wobei die zu sammelnden Elemente Standardelemente und Edelmetalle umfassen, wobei das Verfahren einen Schritt des Sammelns der Standardelemente mit einer ersten Sammelflüssigkeit, gefolgt von einem Schritt des Sammelns der Edelmetalle mit einer zweiten Sammelflüssigkeit umfasst.

14. Verfahren zur Erstellung wenigstens eines Sammelhöhen-Diagramms mit der Vorrichtung nach einem der Ansprüche 1 bis 7 in Abhängigkeit von der Eindringtiefe der Platte in die Nut und dem Volumen der gesammelten Flüssigkeit, umfassend:

A') einen Schritt, bei welchem eine Kalibrierungsplatte mit den Oberflächeneigenschaften der Platten, auf denen Elemente gesammelt werden sollen, mit demselben Durchmesser wie die Kalibrierungsplatte und mit einer Skala, die sich wenigstens vom äußeren Rand der Kalibrierungsplatte radial erstreckt, auf dem Plattenhalter angebracht wird,
Folgende Schritte:
B'): Platzierung der Sammelflüssigkeit in der Sammelnut,
C'): Platzierung des Plattenhalters, der die Kalibrierungsplatte trägt, so dass die Platte bis zu einer bestimmten Eindringtiefe in die Sammelflüssigkeit eindringt,
D'): Aufnahme von Bildern,
dann Wiederholung der Schritte C' und D' durch Ändern der Eindringtiefe der Kalibrierungsplatte in die Sammelnut,
E'): Bestimmung der Sammelhöhe und Berechnung der Sammelfläche für die verschiedenen Eindringtiefen,
F"): Erstellung eines Diagramms, das die Eindringtiefen, das Volumen der Sammelflüssigkeit und die Sammelfläche in Beziehung setzt.

15. Verfahren zur Bestimmung der Oberflächenkonzentration von Metallverunreinigungen einer Platte unter Anwendung des Sammelverfahrens nach einem der Ansprüche 9 bis 13, und umfassend die Verarbeitung der in Schritt D aufgenommenen Bilder zur Bestimmung der Sammelfläche, die Analyse der Sammelflüssigkeit und die Berechnung der Oberflächenkonzentration der Verunreinigungen der Platte.

## Claims

1. Collection device for collecting elements on at least one bevel of a circular plate (W), comprising:

   - a base (2) comprising a collection groove (20) intended to receive a collection liquid,
   - a plate-carrier (6) able to rotate the plate (W) about itself and such that the outer periphery of the plate (W) penetrates into the collection groove (20),
   Said device being **characterized in that** it also comprises :
   - means (22 for visualising the interior of the collection groove (20), enabling at least one image to be acquired of the contact region between the collection liquid and at least one of the two faces of the plate.

2. Collection device according to claim 1, wherein the visualisation means (20) comprise at least one camera intended to be connected to means for display and processing of images, 3. the base (2) advantageously comprising a bore (21) opening into the groove (20), in which a camera is mounted.

3. Collection device according to claim 2, wherein the visualisation means (22) can acquire at least one image of the contact region between the collection liquid and the two faces of the plate, and wherein the base (2) comprises another bore opening into the groove, opposite the first bore, and in which another camera is mounted.

4. Collection device according to one of the claims 1 to 3, comprising illumination means (24) orientated so as to light the collection groove (20) from above.

5. Collection device according to one of the claims 1 to 4, comprising means for modifying the penetration position of the plate (W) into the collection groove (20), said means advantageously comprising a set of shims (30) of different thicknesses intended to be disposed between the plate-carrier (6) and the base (2) or said means advantageously comprising micrometer screws.

6. Collection device according to one of the preceding claims, wherein the bottom of the collection groove (20) comprises a modification of the curvature of the bottom of the groove intended to keep the collection liquid in position and/or comprising means for rotating the plate-carrier so as to rotate the plate about its axis over at least 360° at constant speed.

7. Collection device according to one of the preceding claims, comprising means (27) capable of delivering a controlled gas flow in the collection groove (20) in the collection region, directed opposite to the wetting of the edge of the plate (W) by the collection liquid.

8. Collection system comprising a collection device according to one of the claims 1 to 7 and a processing unit configured to control the penetration position of the plate into the collection groove, the speed of rotation and the rotation, and configured to process images provided by the visualisation means in order to determine a collection surface area.

9. Collection method using the collection device according to one of the claims 1 to 7, comprising:

    A) placing the plate on the plate-carrier,
    B) placing the collection liquid in the collection groove,
    C) placing the plate-carrier such that the plate penetrates into the collection liquid to a given depth,
    D) rotating the plate at a suitable constant speed over at least one complete revolution, and acquiring collection images,
    E) withdrawing the plate,
    F) recovering the collection liquid.

10. Collection method according to claim 9, comprising, prior to step A), a step of placing, on the plate-carrier, a graduated plate having the same diameter as the plate on which it is desired to collect the elements, and comprising graduations extending radially from the outer edge of the plate, a step of acquiring an image of the graduated plate and processing said image of the graduated plate, with the aim of processing the images acquired during the collection.

11. Collection method according to claim 10, wherein the appropriate speed of rotation is determined during the rotation of the graduated plate, said graduated plate acting as a calibration plate.

12. Collection method according to claim 10, wherein graduations are superimposed on the collection images so that the graduations extend radially from the outer edge of the plate.

13. Collection method according to one of the claims 9 to 12, the elements to be collected comprising standard elements and noble metals, said method comprising a step of collecting standard elements using a first collection liquid followed by a step of collecting noble metals using a second collection liquid.

14. Method for establishing at least one chart of the collection height using the device according to one of the claims 1 to 7, based on the penetration depth of the plate into the groove and of the volume of the collection liquid, comprising

    A') a step in which a calibration plate, having the surface condition properties of the wafers on which it is desired to collect the elements and having the same diameter as those wafers and comprising graduations extending radially at least from the outer edge of the calibration plate, is mounted on the plate-carrier, the steps of
    B'): placing the collection liquid in the collection groove,
    C'): placing the plate-carrier carrying the calibration plate such that the plate penetrates into the collection liquid to a given penetration depth,
    D'): acquiring images,
    then repeating steps C' and D' while modifying the penetration depth of the calibration plate into the collection groove,

E') determining the collection height and calculating the collection surface area for the various penetration depths,

F') establishing a chart connecting the penetration depth with the volume of the collection liquid at the collection surface.

15. Method for determining the concentration per unit area of metallic contaminants of a plate using the collection method according to one of the claims 9 to 13, and comprising processing the images acquired in step D to determine the collection surface area, analysing the collection liquid and calculating the surface concentration of contaminants of the plate.

**Fig. 1A**

**Fig. 1D**

**Fig. 1B**

**Fig. 1C**

# Fig. 1E

# Fig. 2

**Fig. 3**

**Fig. 5**

2mm

0,1mm

30

1mm

0,25mm

## Fig. 4A

24

W

16

6.4

6.2

X
X2

U

19

30

18

## Fig. 4B

**Fig. 6**

**Fig. 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **CHRIS M. SPARKS et al.** Novel technique for contamination analysis around the edge, the bevel, and the edge exclusion area of 200 and 300mm silicon wafers. *Proceedings of SPIE 5041, Process and Materials Characterization and Diagnostics in IC manufacturing,* 15 Juillet 2003, vol. 5041, 99-104